# EUROPEAN PATENT APPLICATION

(11) **EP 4 686 727 A1**
(43) Date of publication of application: **04.02.2026**
(21) Application number: 25191791.0
(22) Date of filing: 25.07.2025
(51) Int. Cl.: C08G 59/14, C08G 59/50

(54) **EPOXY RESIN COMPOSITION**

(30) Priority: 02.08.2024 JP 2024128159
(71) Applicant: SHIN-ETSU CHEMICAL CO., LTD., Tokyo 1000005 (JP)
(72) Inventor: MOTEGI, Ryohei, Gunma, 379-0224 (JP); KUSHIHARA, Naoyuki, Gunma, 379-0224 (JP); ITO, Yuri, Gunma, 379-0224 (JP)
(74) Representative: Ipsilon

(57) **Abstract**

One of the purposes of the present invention is to provide an epoxy resin composition having excellent storage stability and curability while being curable at a low temperature in a short period of time. The present invention provides an epoxy resin composition comprising: (A) a non-silicone-modified epoxy resin having two or more epoxy groups per molecule; (B) an aromatic amine-based curing agent having two or more amino groups per molecule, in an effective amount for curing the epoxy resin; (C) a silicone-modified epoxy resin, in an amount of 1 to 200 parts by mass, relative to 100 parts by mass of component (A); (D) an aluminum chelate compound, in an amount of 0.05 parts by mass or more and less than 3.0 parts by mass, relative to 100 parts by mass of the total of components (A), (B), and (C); (E) at least one selected from an alkoxysilane having one or more phenyl groups per molecule and one or more alkoxy groups per molecule, and a partially hydrolyzed condensate of the alkoxysilane, in an amount of 0.5 parts by mass or more and less than 3.0 parts by mass, relative to 100 parts by mass of the total of components (A), (B), and (C); and (F) an inorganic filler, in an amount of 10 parts by mass or more and 1,000 parts by mass or less, relative to 100 parts by mass of the total of components (A), (B), and (C).

## Description

### BACKGROUND

The present invention relates to an epoxy resin composition, and preferably an epoxy resin composition having a liquid form at 25°C.

Epoxy resins are used in a wide range of fields, such as electronic parts, adhesives, and coatings. The properties and curing conditions of epoxy resins vary depending on the type of curing agent used. Therefore, epoxy resins are combined with various curing agents according to their intended applications. Examples of major curing agents include amines, acid anhydrides, and phenols. Among them, aromatic amine curing agents provide cured products with a good balance of adhesion, heat resistance, and other desirable properties, but they have the disadvantage of requiring high-temperature curing.

In recent years, increasing attention has been focused on the development of products that conform to the Sustainable Development Goals (SDGs). For energy conservation, it is desirable for epoxy resins to have shorter curing times or lower curing temperatures. To enhance curability, it is common to add a curing accelerator to the epoxy resin composition.

Composite catalysts composed of, for example, metal complexes and silane compounds have been proposed as curing accelerators for epoxy resins. These composite catalysts do not remain as ionic impurities after promoting the curing of the epoxy resin, allowing for an increased curing rate while preventing migration in the cured product (Patent Literatures 1 and 2).

### PRIOR LITERATURES

### PATENT LITERATURES

[Patent Literature 1] Japanese Patent Application Laid-Open No. 2008-255178
[Patent Literature 2] Japanese Patent Application Laid-Open No. 2012-117033

### SUMMARY

However, adding a curing accelerator to an epoxy resin composition increases the likelihood of the reaction proceeding at room temperature, leading to thickening. This thickening shortens the pot life of the epoxy resin. Therefore, there is a trade-off between increased reactivity and thickening, making it difficult to formulate an epoxy resin composition that achieves both properties.

Accordingly, one of the purposes of the present invention is to provide an epoxy resin composition having excellent storage stability and curability while being curable at a low temperature in a short period of time.

In view of the aforementioned circumstances, the present inventors conducted diligent research and found that the aforementioned problems can be solved by adding an aluminum chelate compound and a silane compound having a phenyl group to an epoxy resin composition containing an epoxy resin and an aromatic amine curing agent, thereby completing the present invention.

That is, the present invention provides an epoxy resin composition defined in the following item [1] below.
[1] An epoxy resin composition comprising:
   (A) a non-silicone-modified epoxy resin having two or more epoxy groups per molecule;
   (B) an aromatic amine-based curing agent having two or more amino groups per molecule, in an effective amount for curing the epoxy resin;
   (C) a silicone-modified epoxy resin, in an amount of 1 to 200 parts by mass, relative to 100 parts by mass of component (A);
   (D) an aluminum chelate compound, in an amount of 0.05 parts by mass or more and less than 3.0 parts by mass, relative to 100 parts by mass of the total of components (A), (B), and (C);
   (E) at least one selected from an alkoxysilane having one or more phenyl groups per molecule and one or more alkoxy groups per molecule, and a partially hydrolyzed condensate of the alkoxysilane, in an amount of 0.5 parts by mass or more and less than 3.0 parts by mass, relative to 100 parts by mass of the total of components (A), (B), and (C); and
   (F) an inorganic filler, in an amount of 10 parts by mass or more and 1,000 parts by mass or less, relative to 100 parts by mass of the total of components (A), (B), and (C).
   The present invention also relates to an epoxy resin composition represented by any of the items [2] to [11] below.
[2] The epoxy resin composition according to the item [1], wherein an amount of component (B) is such that a mole equivalent ratio of an amino group in component (B) per molar equivalent of total epoxy groups in components (A) and (C) is 0.8 equivalents or more and 1.2 equivalents or less.
[3] The epoxy resin composition according to the item [1] or [2], wherein component (C) is a hydrosilylation reaction product of an alkenyl group-containing epoxy resin having a weight-average molecular weight of 500 or higher and an organohydrogen(poly)siloxane containing one or more hydrosilyl groups per molecule.
[4] The epoxy resin composition according to any one of the items [1] to [3], wherein the organohydrogen polysiloxane is represented by one of the following formulas (1) to (3): 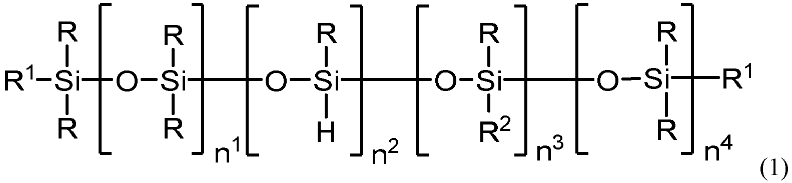
   wherein, in formula (1), each siloxane unit shown in parentheses may randomly bond or may form a block structure, R is a substituted or unsubstituted monovalent hydrocarbon group having 1 to 10 carbon atoms, R¹ is, independently of each other, a hydrogen atom or a monovalent hydrocarbon group having 1 to 10 carbon atoms, R² is a group represented by the following formula (1'), n¹ is an integer of 5 to 200, n² is an integer of 0 to 2, n³ is an integer of 0 to 10, n⁴ is 0 or 1, and the one or more of the R¹ is a hydrogen atom: 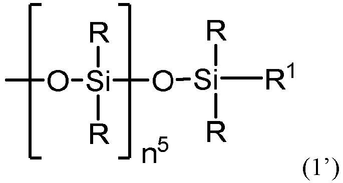
   wherein, in formula (1'), R and R¹ are as defined above, and n⁵ is an integer of 1 to 10: 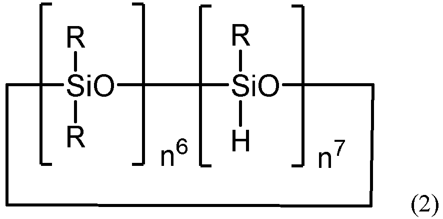
   wherein, in formula (2), each siloxane unit shown in parentheses may randomly bond or may form a block structure, R is as defined above, n⁶ is an integer of 1 to 10, n⁷ is 1 or 2, and n⁶ + n⁷ is 3 to 12: 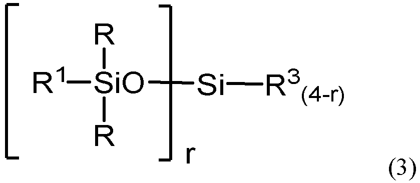
   wherein, in formula (3), R and R¹ are as defined above, r is an integer of 0 to 3, R³ is a hydrogen atom or at least one group selected from an alkyl group having 1 to 10 carbon atoms and an alkoxyalkyl group having 2 to 10 carbon atoms, and one or more of R¹s and R³s are a hydrogen atom.
[5] The epoxy resin composition according to any one of the items [1] to [4], wherein component (D) is a compound represented by the following formula (7): 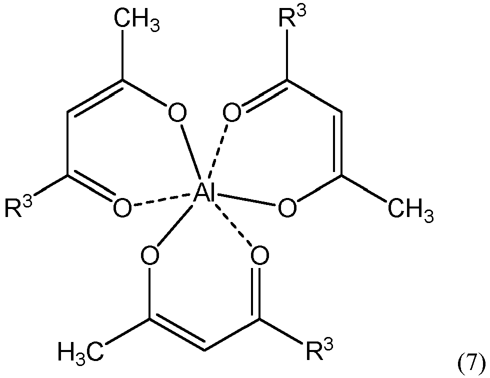 wherein, in formula (7), R³ is, independently of each other, an alkoxy group having 1 to 4 carbon atoms or an alkyl group having 1 to 4 carbon atoms.
[6] The epoxy resin composition according to any one of the items [1] to [5], wherein component (D) is at least one selected from the group consisting of aluminum monoacetylacetonate-bis(ethyl acetoacetate) and aluminum-tris(acetylacetonate).
[7] The epoxy resin composition according to any one of the items [1] to [6], wherein component (E) is an alkoxysilane having one or more phenyl groups per molecule and one or more alkoxy groups having 1 to 4 carbon atoms per molecule.
[8] The epoxy resin composition according to any one of the items [1] to [7], wherein a silane compound of component (E) is a partially hydrolyzed condensate that is an oligomer having a polymerization degree of 5 or lower and containing one or more silanol groups.
[9] The epoxy resin composition according to any one of the items [1] to [7], wherein component (E) is at least one selected from an alkoxysilane represented by the following formula (8): 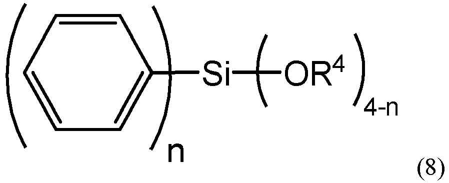
   wherein, in formula (8), R⁴ is an alkyl group having 1 to 4 carbon atoms and n is an integer of 1 to 3,
   and an oligomer having a polymerization degree of 5 or lower that is a partially hydrolyzed condensate of aforesaid alkoxysilane.
[10] The epoxy resin composition according to any one of the items [1] to [9], wherein a mass ratio of component (D) to component (E) satisfies the equation (mass of component D)/(mass of component E) = 1/1 to 1/50.
[11] The epoxy resin composition according to any one of the items [1] to [10], wherein component (F) is the inorganic filler surface-treated with a silane coupling agent.
   The present invention also relates to a potting agent, an underfill agent, an epoxy resin adhesive, and application forms thereof, each comprising the epoxy resin compositions, according to items [12] to [17] below.
[12] A potting agent comprising the epoxy resin composition according to any one of the items [1] to [11].
[13] A power module encapsulated with the potting agent according to the item [12].
[14] An underfill agent comprising the epoxy resin composition according to any one of the items [1] to [11].
[15] A flip-chip package encapsulated with the underfill agent according to the item [14].
[16] An epoxy resin adhesive comprising the epoxy resin composition according to any one of the items [1] to [11].
[17] A semiconductor device comprising a layer formed from the adhesive according to the item [16].

The epoxy resin composition of the present invention provides a cured product that exhibits an excellent pot life with suppressed thickening during storage at room temperature, cures in a short time or at a low temperature, and has good mechanical properties.

### DETAILED DESCRIPTION

The present invention will be described in detail below.

### (A) Epoxy resin

Component (A) of the present invention is a non-silicone-modified epoxy resin having two or more epoxy groups per molecule and serves as the base resin in the epoxy resin composition of the present invention. The epoxy resin preferably has two or more, and more preferably three or more epoxy groups per molecule. Any conventionally known non-silicone-modified epoxy resin can be appropriately selected, as long as it is not modified with silicone. Although component (A) may be either solid or liquid at 25°C, it is preferably in a liquid form at 25°C to ensure ease of handling. Component (A) may be used alone or in combination with two or more thereof. However, when a solid epoxy resin is used, it is preferably blended with a liquid epoxy resin. In such cases, the blending ratio of the solid epoxy resin is preferably 1 to 30 % by mass, more preferably 5 to 20 % by mass, based on the total mass of component (A). This composition provides good handling properties and may also improve the heat resistance of the cured product.

Examples of the epoxy resin having a liquid form at 25°C include a liquid bisphenol A-type epoxy resin, a liquid bisphenol F-type epoxy resin, a liquid naphthalene-type epoxy resin, a liquid aminophenol-type epoxy resin, a liquid hydrogenated bisphenol-type epoxy resin, a liquid alcohol ether-type epoxy resin, a liquid fluorene-type epoxy resin, and a liquid alicyclic epoxy resin. Among them, the bisphenol A-type epoxy resin, the bisphenol F-type epoxy resin, the naphthalene-type epoxy resin, and the aminophenol-type epoxy resin are preferred.

Examples of the epoxy resin that is a solid at 25°C include biphenol-type epoxy resins such as a 3,3',5,5'-tetramethyl-4,4'-biphenol-type epoxy resin and a 4,4'-biphenol-type epoxy resin; a phenol novolac-type epoxy resin, a cresol novolac-type epoxy resin, a bisphenol A novolac-type epoxy resin, a stilbene-type epoxy resin, a triazine skeleton-containing epoxy resin, a fluorene skeleton-containing epoxy resin, a trisphenol alkane-type epoxy resin, a biphenyl-type epoxy resin, a xylylene-type epoxy resin, a biphenyl aralkyl-type epoxy resin, a naphthalene-type epoxy resin, a dicyclopentadiene-type epoxy resin, an alicyclic epoxy resin, and diglycidyl ether compounds of polycyclic aromatics such as anthracene and polyfunctional phenols, and phosphorus-containing epoxy resins obtained by introducing phosphorus compounds into these resins.

Component (A) preferably has a viscosity of 3,000 to 10,000 mPa·s at 25°C. The viscosity is measured using a B-type viscometer in accordance with the Japanese Industrial Standards (JIS) K 7117-1:1999. The epoxy equivalent of component (A) is not particularly limited, but is typically in the range of 80 to 120, and preferably 90 to 180.

The amount of component (A) is preferably 1 to 40 % by mass, more preferably 5 to 30 % by mass, even more preferably 5 to 20 % by mass, relative to the total mass of the epoxy resin composition.

### (B) Aromatic amine-based curing agent

Component (B) of the present invention is an aromatic amine-based curing agent having two or more amino groups per molecule and serves as the curing agent that reacts with component (A) in the epoxy resin composition of the present invention. Component (B) may be one or more curing agents appropriately selected from conventionally known aromatic amine-based curing agents. It may be either solid or liquid at 25°C, but a liquid form is preferred for better handling. Component (B) may be used alone or in combination with two or more of such curing agents; however, when a solid aromatic amine-based curing agent is used, it is preferably combined with a liquid aromatic amine-based curing agent. This improves workability and may also enhance the heat resistance of the cured product.

It is sufficient for the amount of the aromatic amine-based curing agent to be adequate to effectively cure components (A) and (C). Preferably, the amount is such that the molar equivalent ratio of the amino groups in component (B) to the total epoxy groups in components (A) and (C) is from 0.8 to 1.2, and more preferably from 0.9 to 1.1. If the molar ratio exceeds the preferred range, curability may be impaired.

Examples of aromatic amine-based curing agents having a liquid form at 25°C include 3,3'-diethyl-4,4'-diaminodiphenylmethane, 2,4-diamino-3,5-diethyltoluene, 2,6-diamino-3,5-diethyltoluene, and dimethylthiotoluenediamine. Among them, 3,3'-diethyl-4,4'-diaminodiphenylmethane is preferred.

Examples of aromatic amine-based curing agents that are solid at 25°C include 4,4'-methylenebis(2-ethyl-6-methylaniline), 2,2'-diisopropyl-6,6'-dimethyl-4,4'-methylenedianiline, 2,2',6,6'-tetraisopropyl-4,4'-methylenedianiline, 4,4'-methylenebis(2,6-diethylaniline), 4,4'-methylenebis(3-chloro-2,6-diethylaniline), 1,3-phenylenediamine, 2,4-diaminotoluene, 2,6-diaminotoluene, 2,4,6-trimethyl-1,3-phenylenediamine, 3-aminobiphenyl, 3-amino-4-methoxybiphenyl, 2-aminofluorene, 2-amino-9-fluorenone, 2,7-diaminofluorene, 3-aminobenzophenone, 3,4'-diaminodiphenylmethane, 3,3'-diaminodiphenylmethane, 3,4-diaminobenzophenone, and 3,3'-diaminobenzophenone. Among them, 4,4'-methylenebis(2-ethyl-6-methylaniline) is preferred.

### (C) Silicone-modified epoxy resin

Component (C) is a silicone-modified epoxy resin. By the use of a silicone-modified epoxy resin, the curability and moisture resistance reliability of the epoxy resin composition are increased. Examples of the silicone-modified epoxy resin include a copolymer obtained by subjecting an alkenyl group-containing epoxy resin and an organohydrogen polysiloxane to a hydrosilylation reaction. More preferably, component (C) of the present invention does not contain 1,3-bis(3-glycidoxypropyl)-1,1,3,3-tetramethyldisiloxane.

Examples of the alkenyl group-containing epoxy resin include the following formulas (4) to (6).

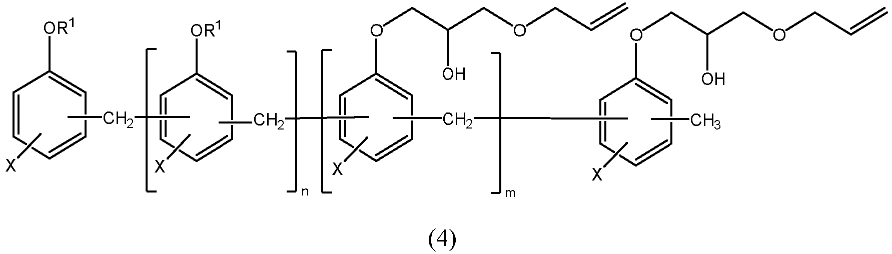

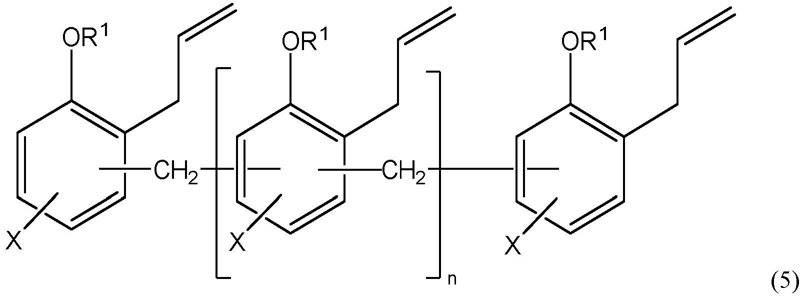

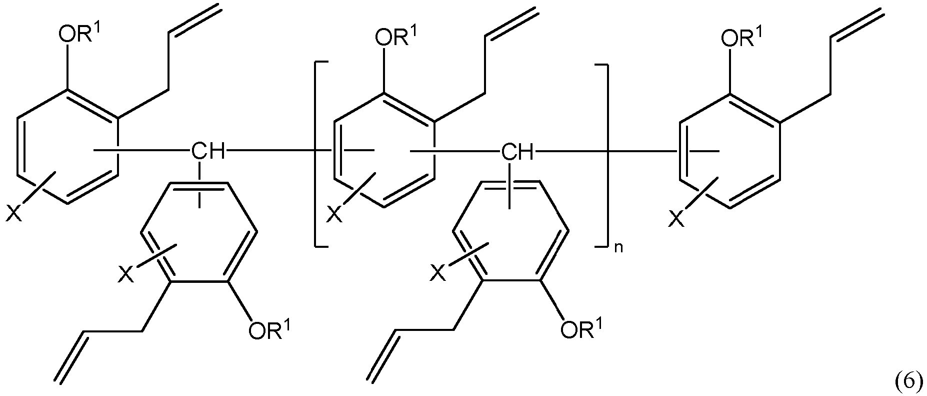

In formulas (4) to (6) above, R¹ is a glycidyl group (2,3-epoxypropyl group), X is, independently of each other, a hydrogen atom or a bromine atom, and n is a number of 0 or higher, preferably a number of 0 to 50, more preferably a number of 1 to 20. m is an integer of 0 or higher, preferably a number of 1 to 5, more preferably 1.

The organohydrogen polysiloxane is preferably an organohydrogen polysiloxane represented by one of the following formulas (1) to (3), containing one or more hydrosilyl groups per molecule. Among them, an organohydrogen polysiloxane represented by the following formula (1) is more preferred. 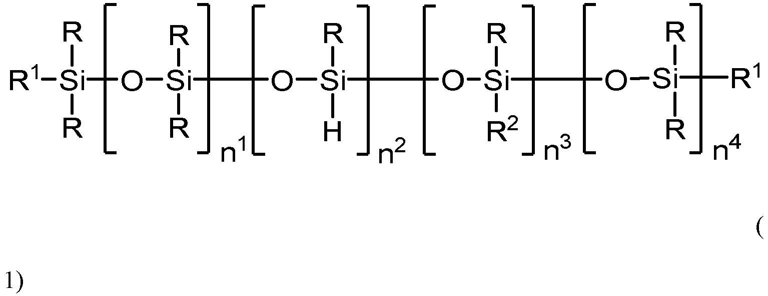 In formula (1), each siloxane unit shown in parentheses may randomly bond or may form a block structure, R is a substituted or unsubstituted, monovalent hydrocarbon group having 1 to 10 carbon atoms, R¹ is, independently of each other, a hydrogen atom or a monovalent hydrocarbon group having 1 to 10 carbon atoms, R² is a group represented by the following formula (1'), n¹ is an integer of 5 to 200, n² is an integer of 0 to 2, n³ is an integer of 0 to 10, n⁴ is 0 or 1, and one or more of R¹s are a hydrogen atom. 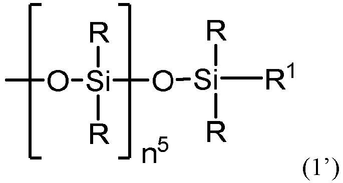 In formula (1'), R and R¹ are as defined above and n⁵ is an integer of 1 to 10. 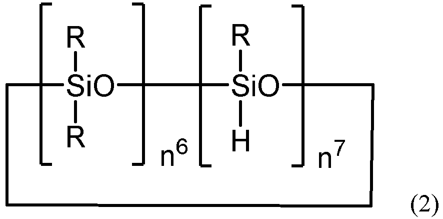 **In** formula (2), each siloxane unit shown inside the parentheses may randomly bond or may form a block structure, R is as defined above, n⁶ is an integer of 1 to 10, n⁷ is 1 or 2, and n⁶ + n⁷ is 3 to 12. 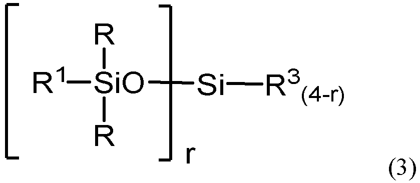 In formula (3), R and R¹ are as defined above, r is an integer of 0 to 3, R³ is a hydrogen atom or at least one group selected from an alkyl group having 1 to 10 carbon atoms and an alkoxyalkyl group having 2 to 10 carbon atoms, and one or more of R¹s and R³s are a hydrogen atom.

In formula (1), R is a substituted or unsubstituted monovalent hydrocarbon group having 1 to 10 carbon atoms. Examples of the monovalent hydrocarbon group include alkyl groups such as a methyl group, an ethyl group, an n-propyl group, an isopropyl group, an n-butyl group, an isobutyl group, a *tert*-butyl group, a pentyl group, a neopentyl group, a hexyl group, a cyclohexyl group, an octyl group, and a decyl group; an aryl group such as a phenyl group and a tolyl group; and aralkyl groups such as a benzyl group and a phenylethyl group.

R¹ is, independently of each other, a hydrogen atom or a monovalent hydrocarbon group having 1 to 10 carbon atoms, with the proviso that one or more of the R¹s are a hydrogen atom. Examples of the monovalent hydrocarbon group include the aforementioned examples defined for R.

R² is a group represented by formula (1') above. n¹ is an integer of 5 to 200, preferably 9 to 150. n² is an integer of 0 to 2, preferably 0 to 1. n³ is an integer of 0 to 10, preferably 0 to 5. n⁴ is 0 or 1. In formula (1'), R and R¹ are as defined above, and n⁵ is an integer of 1 to 10, preferably 1 to 4.

In formula (2), R is as defined above, and n⁶ is an integer of 1 to 10, preferably 1 to 5. n⁷ is 1 or 2. n⁶ + n⁷ is an integer of 3 to 12, preferably 3 to 7.

In formula (3), R and R¹ are as defined above, r is an integer of 0 to 3, and R³ is a hydrogen atom or at least one group selected from an alkyl group having 1 to 10 carbon atoms, preferably 1 to 4 carbon atoms, and an alkoxyalkyl group having 2 to 10 carbon atoms, preferably 2 to 4 carbon atoms. One or more of R¹s or R³s are a hydrogen atom.

Examples of the organohydrogen polysiloxane may include compounds of the following formulas:

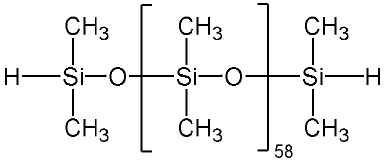

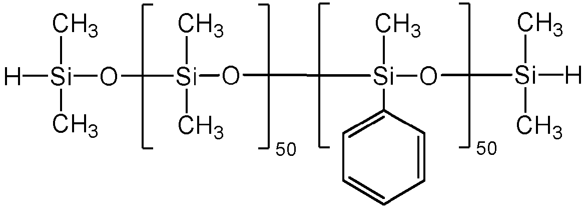

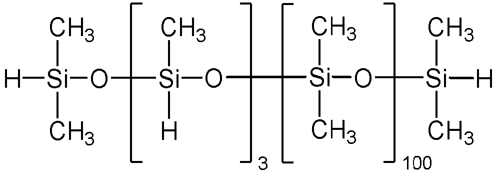

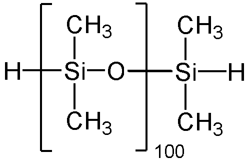

The organohydrogen polysiloxane has a weight-average molecular weight of preferably 100 to 100,000, more preferably 500 to 20,000. When the weight-average molecular weight of the organohydrogen polysiloxane is within these ranges, there appears a uniform structure in which the organohydrogen polysiloxane is uniformly dispersed in a matrix, or a sea-island structure in which the organohydrogen polysiloxane forms fine layer separation in a matrix, according to the structure or weight-average molecular weight of the alkenyl group-containing epoxy resin to be reacted with the organohydrogen polysiloxane.

A uniform structure is formed when the weight-average molecular weight of the organohydrogen polysiloxane is relatively small, particularly 100 to 10,000. A sea-island structure is formed when the weight-average molecular weight of the organohydrogen polysiloxane is relatively large, particularly 10,000 to 100,000. A uniform structure or a sea-island structure may be selected depending on the intended application. When the weight-average molecular weight of the organohydrogen polysiloxane is less than 100, the resulting cured product tends to be rigid and brittle. On the other hand, if the weight-average molecular weight exceeds 100,000, the sea-island domains become large, which may lead to the generation of localized stress in the cured product.

In the present invention, the weight-average molecular weight refers to the value determined by gel permeation chromatography (GPC), using polystyrene as the reference standard, under the following conditions.
GPC measurement conditions:
Developing solvent: Tetrahydrofuran
Flow rate: 0.6 mL/min
Column: TSK Guard column Super H-L
TSK gel Super H4000 (6.0 mm I. D.×15 cm×1)
TSK gel Super H3000 (6.0 mm I. D.×15 cm×1)
TSK gel Super H2000 (6.0 mm I. D.×15 cm×2), each available from Tosoh Corporation
Column temperature: 40°C
Sample injection amount: 20 µL (Sample concentration: 0.5% by mass-tetrahydrofuran solution)
Detector: Differential refractometer (RI)

Examples of methods for reacting the alkenyl group-containing epoxy resin with the organohydrogen polysiloxane include known methods, such as addition reactions carried out in the presence of a platinum-based catalyst. Through such reactions, a silicone-modified epoxy resin can be obtained. Preferably, the organohydrogen polysiloxane is used in an amount such that it provides 0.1 to 1 mol of Si-H groups per mol of alkenyl groups in the alkenyl group-containing epoxy resin.

The amount of the silicone-modified epoxy resin (C) is preferably 1 to 200 parts by mass, more preferably 5 to 150 parts by mass, even more preferably 10 to 100 parts by mass, relative to 100 parts by mass of the epoxy resin (A).

### (D) Aluminum chelate compound

Component (D) of the epoxy resin composition of the present invention is an aluminum chelate compound, and is a catalyst component that promotes curing of the epoxy resin. Component (D) functions to the epoxy as part of a composite catalyst system in conjunction with component (E), which will be described below. The curing reaction cannot be sufficiently promoted in the absence of either component.

Examples of component (D) include compounds in which diketonate ligands are coordinated to aluminum, as represented by the following formula (7). 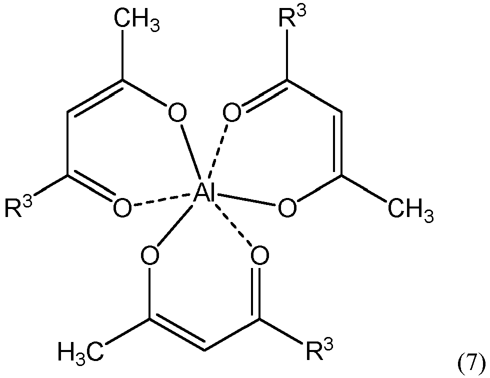 **In** formula (7), R³ is, independently of each other, an alkoxy group having 1 to 4 carbon atoms or an alkyl group having 1 to 4 carbon atoms. Examples of the alkoxy group include a methoxy group and an ethoxy group, and examples of the alkyl group include a methyl group and an ethyl group.

Examples of the aluminum chelate compound represented by formula (7) include aluminum-tris(ethyl acetoacetate), aluminum monoacetylacetonate-bis(ethyl acetoacetate), and aluminum-tris(acetylacetonate). These may be used alone or in combination with two or more thereof. Among them, preferred is aluminum-tris(acetylacetonate), which does not thicken easily at room temperature after mixing.

The amount of component (D) is 0.05 parts by mass or more and less than 3.0 parts by mass, preferably 0.1 to 2.0 parts by mass, more preferably 0.2 to 1 part by mass, relative to total 100 parts by mass of components (A), (B), and (C).

### (E) Silane compound having phenyl group

Component (E) of the present invention is a silane compound having one or more phenyl groups per molecule and used in combination with component (D) to make a catalyst component which promotes curing of an epoxy resin.

Component (E) has one or more phenyl groups per molecule, and is at least one selected from an alkoxysilane having one or more alkoxy groups per molecule and a partially hydrolyzed condensate of the alkoxysilane, and may contain a partially hydrolyzed condensate of an alkoxysilane compound. The partially hydrolyzed condensate is an oligomer in which some alkoxysilanes are hydrolyzed and condensed with other alkoxysilanes. Preferred is an oligomer that is a hydrolytic condensate having a polymerization degree of 5 or less.

Component (E) is preferably at least one selected from an alkoxysilane having an alkoxy group and a phenyl group represented by the following formula (8) and an oligomer having a polymerization degree of 5 or less that is a partially hydrolyzed condensate of the alkoxysilane.

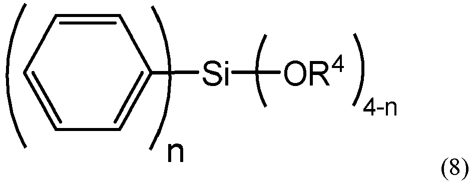

In formula (8), R⁴ is an alkyl group having 1 to 4 carbon atoms, and examples of R⁴ include a methyl group, an ethyl group, and an isopropyl group. Among them, a methyl group is preferred. n is an integer of 1 to 3. n is preferably 2 or 3, more preferably 2, in view of ensured preferred reactivity and increased pot life.

Examples of component (E) include diphenyldimethoxysilane, diphenyldiethoxysilane, diphenyldiisopropoxysilane, and methoxytriphenylsilane. These may be used alone or in combination with two or more of these. Among them, diphenyldimethoxysilane is more preferred. A partially hydrolyzed condensate of such an alkoxysilane compound may be used. The partially hydrolyzed condensate is preferably an oligomer having a polymerization degree of 5 or lower.

The amount of component (E) is 0.5 parts by mass or more and less than 3.0 parts by mass, preferably 0.8 to 2.5 parts by mass, more preferably 1.0 to 2.0 parts by mass, relative to total 100 parts by mass of components (A), (B), and (C).

The working mechanism of the composite catalyst of the present invention will be explained below in detail.

In the present invention, the two components, the aluminum chelate compound (D) and the silane compound (E) having a phenyl group, are added to the epoxy resin composition and act on the epoxy resin as a composite catalyst to promote curing. At this time, the substituent group of the silane compound (E) is as bulky as a phenyl group and suppresses the action with the aluminum chelate compound (D) at room temperature, but the thermal motion of an amino group in component (B) is stimulated by heating when used, allowing the aluminum chelate compound (D) and the silane compound (E) to act more easily. The composite formed by the interaction of the two components exhibits enhanced catalytic activity as a Brønsted acid, due to electron delocalization in the phenyl group. The synergistic mechanism of these two components may enable the epoxy resin composition of the present invention to achieve both a long pot life and excellent curability.

The mass ratio of component (D) to component (E) in the epoxy resin composition of the present invention preferably satisfy the equation (mass of component D)/(mass of component E) = 1/1 to 1/50, more preferably 1/1 to 1/20, more preferably 1/2 to 1/10. When the mass ratio is within these ranges, the epoxy resin composition having both a long pot life and excellent curability is provided.

### (F) Inorganic filler

The component (F) is an inorganic filler, and is added to reduce the thermal expansion coefficient and improve the moisture/heat resistance reliability of the composition.

Examples of the inorganic filler include silicas such as fused silica, crystalline silica, and cristobalite; and alumina, silicon nitride, aluminum nitride, boron nitride, titanium oxide, glass fiber, and magnesium oxide. These inorganic fillers may be used alone or in combination. The average particle size and shape of these inorganic fillers may be selected depending on the application. Among them, preferred are spherical alumina, spherical fused silica, and glass fiber. The average particle size of the inorganic filler is, for example, preferably 1 to 100 µm, more preferably 5 to 90 µm, even more preferably 10 to 80 µm. Herein, the average particle size refers to the volume-based 50% cumulative distribution diameter, as measured by dynamic light scattering using laser light.

Preferably, the inorganic filler is surface-treated with a silane coupling agent. Examples of the silane coupling agent for treating the inorganic filler include an aminosilane coupling agent, an epoxy silane coupling agent, a vinylsilane coupling agent, a methacrylic silane coupling agent, an acrylic silane coupling agent, a mercaptosilane coupling agent, a triazine functional group-type silane coupling agent, an isocyanate functional group-type silane coupling agent, an isocyanuric acid functional group-type silane coupling agent, a benzotriazole functional group-type silane coupling agent, an acid anhydride functional group-type silane coupling agent, an azasilacyclopentane functional group-type silane coupling agent, an imidazole functional group-type silane coupling agent, and an unsaturated group-containing silane coupling agent. Component (F) of the present invention is preferably the inorganic filler surface-treated with at least one silane coupling agent selected from the aforementioned silane coupling agents.

Examples of the aminosilane coupling agent include N-2-(aminoethyl)-3-aminopropyltrimethoxysilane, 3-aminopropyltriethoxysilane, N-phenyl-3-aminopropyltrimethoxysilane, 3-aminopropyltriethoxysilane, 3-triethoxysilyl-N-(1,3-dimethyl-butylidene)propylamine, and N-phenyl-3-aminopropyltrimethoxysilane.

Examples of the epoxy silane coupling agent include 3-glycidoxypropyltrimethoxysilane, 3-glycidoxypropylmethyldiethoxysilane, 2-(3,4-epoxycyclohexyl)ethyltrimethoxysilane, and 8-glycidoxyoctyltrimethoxysilane.

Examples of the vinylsilane coupling agent include vinyltrimethoxysilane and vinyltriethoxysilane.

Examples of the methacrylic silane coupling agent include 3-methacryloxypropylmethyldimethoxysilane, 3-methacryloxypropyltrimethoxysilane, 3-methacryloxypropylmethyldiethoxysilane, 3-methacryloxypropyltriethoxysilane, and 8-methacryloxyoctyltrimethoxysilane.

Examples of the acrylic silane coupling agent include 3-acryloxypropyltrimethoxysilane.

Examples of the mercaptosilane coupling agent include 3-mercaptopropylmethyldimethoxysilane and 3-mercaptopropyltrimethoxysilane.

The amount of the silane coupling agent, relative to the inorganic filler, is not particularly limited. A conventional process may be used to carry out surface treatment of the inorganic filler with the aforementioned silane coupling agent. It is noted that, in the present invention, the aforementioned silane coupling agent is used to carry out the surface treatment of the inorganic filler. The epoxy resin composition of the present invention contains the inorganic filler that is surface-treated beforehand with the aforementioned silane coupling agent, but the epoxy resin composition does not contain the aforementioned silane coupling agent as a component. Accordingly, in the most preferred embodiments of the epoxy resin composition of the present invention, the aforementioned silane coupling agent is not contained. More preferably, the epoxy resin composition of the present invention does not contain aminosilane coupling agents, epoxy silane coupling agents, or vinylsilane coupling agents such as vinyltrimethoxysilane.

The amount of the component (F) is 10 parts by mass or more and 1,000 parts by mass or less, preferably 100 to 750 parts by mass, more preferably 200 to 500 parts by mass, relative to total 100 parts by mass of components (A), (B), and (C).

### Other additives

Another additive, other than the aforementioned components (A) to (F), may be added to the epoxy resin composition of the present invention, if necessary, as long as the objects and effects of the present invention are not impaired. Examples of the additive include a colorant, a flame retardant, an antioxidant, an adhesive aid, a stress-reducing agent, and an antifoaming agent. The amount of the other additive varies depending on the application of the epoxy resin composition of the present invention, and may be appropriately adjusted insofar as the effects of the present invention are not impaired. For example, the total amount of such other additives may be equal to or less than 5% by mass relative to the total mass of the epoxy resin composition.

When the epoxy resin composition of the present invention is stored at room temperature, it may be stored in two separate liquid compositions. In such a case, the base resin component may comprise component (A), component (C), and part of component (F), and the curing agent component may comprise component (B) and the other part of component (F). Component (D) and component (E) may be added to either the base resin component or the curing agent component, or to both. In other words, in the present invention, it is preferred to provide a two-component kit for obtaining the epoxy resin composition, in which the two-component kit contains a first agent (the base resin component) containing component (A), component (C), and a portion of component (F) mentioned above, and a second agent (the curing agent component) containing component (B) and the remainder of component (F), and wherein component (D), component (E), and other optional components are contained in either the first agent or the second agent, or to both. The mixing ratio of the first agent (the resin component) to the second agent (the curing agent component) may be adjusted such that the amounts of components (A) to (F) in the total composition fall within the aforementioned ranges.

The epoxy resin composition of the present invention preferably has a liquid form at 25°C. The epoxy resin composition has a viscosity at 25°C of 10 to 500 Pa·s, preferably 20 to 400 Pa·s, more preferably 30 to 300 Pa·s. The viscosity is determined at 25 °C with a rotational viscometer in accordance with JIS Z 8803:2011.

### Method for preparing epoxy resin composition

The method for preparing the epoxy resin composition of the present invention is not particularly limited. Components (A) to (F) may be, for example, mixed, stirred, dissolved, and/or dispersed, simultaneously or separately, while performing heat processing, if necessary, to form a composition. The devices used to carry out the mixing, stirring, and dispersion in the preparation method are not particularly limited. For example, a milling machine equipped with a stirrer and a heater, a two-roll mill, a three-roll mill, a ball mill, a planetary mixer, or a masscolloider may be used, and these devices may be used in combination as appropriate.

The curing conditions of the epoxy resin composition of the present invention are not particularly limited and may include, for example, heating at a temperature of 60 to 200°C, preferably 80 to 180°C, for 30 minutes to 10 hours, preferably 1 to 5 hours. The epoxy resin composition of the present invention may be sufficiently cured at a low temperature and in a short period of time. Accordingly, sufficient curing is possible at a temperature of 100 to 120°C for 1 to 2 hours.

The present invention further provides a potting agent containing the aforementioned epoxy resin composition. The blending ratio of the epoxy resin composition contained in the potting agent may be set according to conventionally-known potting agents. The present invention provides a power module encapsulated with the potting agent. The sealing method of the power module with the potting agent is not particularly limited.

The present invention further provides an underfill agent containing the aforementioned epoxy resin composition. The blending ratio of the epoxy resin composition contained in the underfill agent may be set according to conventionally-known underfill agents. The present invention provides a flip-chip package encapsulated with the aforementioned underfill agent. The sealing method of the chip with the underfill agent is not particularly limited.

The present invention further provides an epoxy resin adhesive containing the aforementioned epoxy resin composition. The blending ratio of the epoxy resin composition contained in the adhesive may be set according to conventionally-known epoxy resin adhesives. The present invention provides a semiconductor device having a layer formed from the aforementioned adhesive. The method for manufacturing the semiconductor device is not particularly limited.

### EXAMPLES

Some of the present embodiments will be explained below in further detail with reference to a series of Examples and Comparative Examples, but the present invention is in no way limited by these Examples.

### Examples 1 to 5 and Comparative Examples 1 to 8

The components shown below were mixed at 25°C in the compositions shown in Tables 1 and 2 to prepare epoxy resin compositions.

### (A) Epoxy resin

Epoxy resin (A1), liquid at 25°C: Bisphenol A-type epoxy resin (YD-8125: available from Nippon Steel Chemical & Material Co., Ltd.)
Epoxy resin (A2), liquid at 25°C: Aminophenol-type trifunctional epoxy resin (jER630: available from Mitsubishi Chemical Corporation)

### (B) Aromatic amine-based curing agent

Aromatic amine-based curing agent, liquid at 25°C: 3,3'-diethyl-4,4'-diaminodiphenylmethane (Kayahard AA: available from Nippon Kayaku Co., Ltd.)

### (C) Silicone-modified epoxy resin

To a four-neck flask having an internal volume of 1 liter and equipped with a reflux condenser, a thermometer, a stirrer, and a dropping funnel, were placed 200 g of phenol novolac resin modified with allyl glycidyl ether (having a phenol equivalent of 125 and an allyl equivalent of 1,100), as represented by the following formula (15): 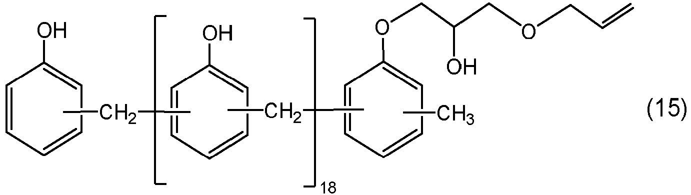 800 g of chloromethyloxirane and 0.6 g of cetyltrimethylammonium bromide, and the resulting was heated and mixed with stirring for 3 hours at 110°C. To the mixture, after cooling to 70 °C and reducing the pressure to 160 mmHg, was added 128 g of a 50% aqueous solution of sodium hydroxide dropwise over 3 hours under azeotropic dehydration. The solvent was removed from the resulting mixture by evaporation under reduced pressure. The residue was then dissolved in a mixed solvent of 300 g of methyl isobutyl ketone and 300 g of acetone, followed by washing. Afterward, the solvent was removed by evaporation under reduced pressure to obtain an allyl group-containing epoxy resin (having an allyl equivalent of 1,590 and an epoxy equivalent of 190), as represented by the following formula (16): 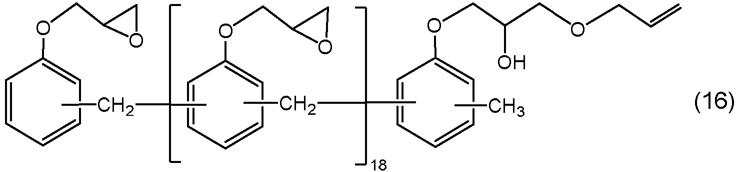 Into the epoxy resin thus obtained, were added 170 g of methyl isobutyl ketone, 330 g of toluene, and 0.07 g of a 2-ethylhexanol-modified chloroplatinic acid solution containing 2% by mass of platinum. The resulting mixture was subjected to azeotropic dehydration for 1 hour. Thereafter, 133 g of organopolysiloxane having a weight-average molecular weight of 8,000, as represented by the following formula (12): 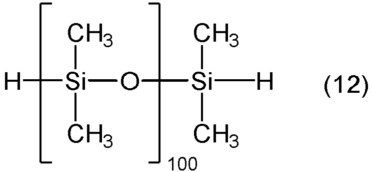 was added dropwise to the mixture over a period of 30 minutes at a reflux temperature. The reaction was continued with stirring for 4 hours at the same temperature. The obtained product was washed and, then, the solvent was removed by evaporation under reduced pressure to obtain a solid copolymer having yellowish white opaque appearance. The solid copolymer had the epoxy equivalent of 280, the ICI melt viscosity of 800 mPa·s as determined at 150°C using a cone-plate viscometer in accordance with ASTM D4287, and the silicon content of 31% by mass.

### (D) Aluminum chelate compound

(D1) Aluminum-tris(acetylacetonate) (aluminum chelate A: available from Kawaken Fine Chemicals Co., Ltd.)
(D2) Aluminum monoacetylacetonate-bis(ethyl acetoacetate) (aluminum chelate D: available from Kawaken Fine Chemicals Co., Ltd.)

### (E) Diphenyldimethoxysilane (KBM-202SS: available from Shin-Etsu Chemical Co., Ltd.)

### (F) Spherical silica having volume average particle size of 15 µm, which is surface-treated with N-phenyl-3-aminopropyltrimethoxysilane

Curing accelerator for comparison: Triphenylphosphine triphenylborane (TPP-S: available from Hokko Chemical Industry Co., Ltd.)

Siloxane compound for comparison: 1,3-Bis(3-glycidoxypropyl)-1,1,3,3-tetramethyldisiloxane

Silane compound for comparison: Vinyltrimethoxysilane (KBM-1003: available from Shin-Etsu Chemical Co., Ltd.)

Silane coupling agent for comparison: 3-Triethoxysilyl-*N*-(1,3-dimethylbutylidene)propylamine (KBE-9103P: available from Shin-Etsu Chemical Co., Ltd.)

### Evaluations

The epoxy resin compositions of Examples 1 to 5 and Comparative Examples 1 to 8 were evaluated according to the following test methods. The results are shown in Table 2.

### (1) Curability

The freshly prepared epoxy resin compositions were molded at 120°C for 60 minutes. Samples from which cured products were successfully obtained are rated as "Good", whereas samples in which the cured products were damaged during mold release due to insufficient curing are rated as "Poor". The results are shown in Table 2.

### (2) Bending strength

The bending strength of the cured products prepared under the aforementioned curing conditions was determined in accordance with JIS K 6911:2006. The results are shown in Table 2.

### (3) Flexural modulus

The flexural modulus of the cured products prepared under the aforementioned curing conditions was determined in accordance with JIS K 6911:2006. The results are shown in Table 2.

### (4) Peak exothermic temperature

The peak exothermic temperature due to the curing reaction of the epoxy resin composition was determined using a differential scanning calorimeter (DSC). Ten milligrams of the aforementioned epoxy resin composition were placed in a 40 µL aluminum sample pan. The temperature was then increased from 25 °C to 300 °C at a heating rate of 10 °C/min, and the peak exothermic temperature was obtained from the peak of the resulting thermogram. The results are shown in Table 2.

### (5) Viscosity increase ratio

The viscosity of the epoxy resin composition at 25 °C was measured using a rotational viscometer in accordance with JIS Z 8803:2011.

After storage for 12 hours at 25°C, the viscosity was measured again by the same method. The viscosity increase ratio was calculated as the ratio of the viscosity after storage to that before storage, i.e., (viscosity after storage) / (viscosity before storage). The results are shown in Table 2.

**[Table 1]**

| | | Example 1 | Example 2 | Example 3 | Example 4 | Example 5 |
|---|---|---|---|---|---|---|
| (A) | Epoxy resin (A1) | 55 | 60 | 55 | | |
| | Epoxy resin (A2) | | | | 45 | 45 |
| (B) | Amine curing agent | 25 | 25 | 25 | 35 | 35 |
| (C) | Silicone-modified epoxy resin | 20 | 15 | 20 | 20 | 20 |
| Comparative Siloxane compound | 1,3-Bis(3-glycidoxypropyl)-1,1,3,3-tetramethyl disiloxane | | | | | |
| (D) | Aluminum chelate compound (D1) | 0.5 | 0.5 | | 0.5 | |
| | Aluminum chelate compound (D2) | | | 0.2 | | 0.3 |
| (E) | Silane compound | 1 | 1 | 2 | 1 | 1 |
| Comparative Silane compound | Vinyltrimethoxysilane | | | | | |
| (F) | Inorganic filler | 400 | 400 | 400 | 400 | 400 |
| Comparative Curing Accelerator | TPP-S | | | | | |
| | Ratio of a mass component (D)/ component (C) | 1/2 | 1/2 | 1/10 | 1/2 | 1/3.3 |
| Evaluation | Curability, 120°C and 60 minutes | Good | Good | Good | Good | Good |
| | Bending strength, MPa | 125 | 120 | 120 | 115 | 125 |
| | Flexural modulus, GPa | 17.5 | 17.6 | 16.1 | 18.8 | 18.9 |
| | DSC heat peak temperature, °C | 165 | 165 | 150 | 170 | 170 |
| | Viscosity increase ratio, viscosity after storage/viscosity before storage | 2.3 | 2.3 | 3.3 | 1.8 | 2.0 |

**[Table 2]**

| | | Com. Ex.1 | Com. Ex.2 | Com. Ex.3 | Com. Ex.4 | Com. Ex.5 | Com. Ex.6 | Com. Ex.7 | Com. Ex.8 |
|---|---|---|---|---|---|---|---|---|---|
| (A) | Epoxy resin(A1) | 55 | 55 | 55 | 55 | 55 | 55 | 55 | |
| | Epoxy resin(A2) | | | | | | | | 60 |
| (B) | Amine curing agent | 25 | 25 | 25 | 25 | 25 | 25 | 25 | 40 |
| (C) | Silicone-modified epoxy resin | 20 | 20 | 20 | 20 | 20 | | 20 | |
| Comparative Siloxane compound | 1,3-Bis(3-glycidoxypropyl)-1,1,3,3-tetramethyl disiloxane | | | | | | 20 | | |
| (D) | Aluminum chelate compound (D1) | 0.5 | | | 0.5 | 0.5 | 0.5 | | |
| | Aluminum chelate compound (D2) | | | | | | | 0.2 | 0.5 |
| (E) | Silane compound | | 1 | | 1.5 | | 1 | 11 | 1 |
| Comparative Silane compound | Vinyltrimethoxysilane | | | | | 1 | | | |
| (F) | Inorganic filler | 400 | 400 | 400 | | 400 | 400 | 400 | 400 |
| Comparative Silane coupling agent | 3-Triethoxysilyl-*N*-(1,3-dimethyl-butylidene)propylamine | | | | 1.5 | | | | |
| Comparative Curing Accelerator | TPP-S | | | 0.5 | | | | | |
| | Ratio of a mass component (D)/ component (C) | - | - | - | 1/3 | 1/2 | 1/2 | 1/55 | 1/2 |
| Evaluation | Curability, 120°C and 60 minutes | Poor | Poor | Poor | Good | Good | Good | Good | Good |
| | Bending strength, MPa | N.D. | | | 65 | 90 | 85 | 100 | 125 |
| | Flexural modulus, GPa | | | | 3.3 | 17.4 | 17.5 | 17.0 | 20.5 |
| | DSC heat peak temperature, °C | 190 | 190 | N.D. | 185 | 170 | 175 | 120 | 165 |
| | Viscosity increase ratio, viscosity after storage/viscosity before storage | 1.5 | 1.5 | | 1.3 | 1.9 | 2.2 | 6.7 | 1.9 |

In the epoxy resin composition of Comparative Examples 1 and 2, to which one of component (D) or component (E) of the present invention was added, thickening at 25°C was suppressed, but sufficient cured products could not be obtained at 120°C for 60 minutes. In the epoxy resin composition of Comparative Example 3, in which triphenylphosphine-triphenylborane was used as the curing accelerator instead of components (D) and (E) of the present invention, curing started immediately after addition, and the evaluation items could not be determined. In the epoxy resin composition of Comparative Example 4, in which 3-triethoxysilyl-N-(1,3-dimethylbutylidene)propylamine was added as a silane coupling agent for comparison instead of the inorganic filler surface-treated with the silane coupling agent, the DSC peak exothermic temperature was relatively high, indicating low reactivity. The bending strengths were poor in both Comparative Example 5, in which vinyltrimethoxysilane was added as a silane compound for comparison, and Comparative Example 6, in which 1,3-bis(3-glycidoxypropyl)-1,1,3,3-tetramethyldisiloxane was added as a siloxane compound for comparison. In the epoxy resin composition of Comparative Example 7, in which component (E) of the present invention was added in an amount exceeding the upper limit, the viscosity increase ratio was high, and the bending strength was poor. In the epoxy resin composition of Comparative Example 8, in which a silicone-modified epoxy resin was not added, the flexural modulus ratio was high.

In contrast, the epoxy resin composition of the present invention has an excellent pot life in which thickening during storage at room temperature is suppressed, and sufficiently cures in a short period of time or at a low temperature to provide a cured product exhibiting excellent mechanical properties, such as a high flexural modulus and bending strength.

## Claims

1. An epoxy resin composition comprising:
(A) a non-silicone-modified epoxy resin having two or more epoxy groups per molecule;
(B) an aromatic amine-based curing agent having two or more amino groups per molecule, in an effective amount for curing the epoxy resin;
(C) a silicone-modified epoxy resin, in an amount of 1 to 200 parts by mass, relative to 100 parts by mass of component (A);
(D) an aluminum chelate compound, in an amount of 0.05 parts by mass or more and less than 3.0 parts by mass, relative to 100 parts by mass of the total of components (A), (B), and (C);
(E) at least one selected from an alkoxysilane having one or more phenyl groups per molecule and one or more alkoxy groups per molecule, and a partially hydrolyzed condensate of the alkoxysilane, in an amount of 0.5 parts by mass or more and less than 3.0 parts by mass, relative to 100 parts by mass of the total of components (A), (B), and (C); and
(F) an inorganic filler, in an amount of 10 parts by mass or more and 1,000 parts by mass or less, relative to 100 parts by mass of the total of components (A), (B), and (C).

2. The epoxy resin composition according to claim 1, wherein an amount of component (B) is such that a mole equivalent ratio of an amino group in component (B) per molar equivalent of total epoxy groups in components (A) and (C) is 0.8 equivalents or more and 1.2 equivalents or less.

3. The epoxy resin composition according to claim 1, wherein component (C) is a hydrosilylation reaction product of an alkenyl group-containing epoxy resin having a weight-average molecular weight of 500 or higher and an organohydrogen(poly)siloxane containing one or more hydrosilyl groups per molecule.

4. The epoxy resin composition according to claim 3, wherein the organohydrogen polysiloxane is represented by one of the following formulas (1) to (3): 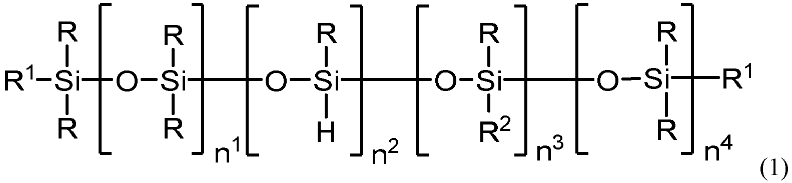
wherein each siloxane unit shown in parentheses may randomly bond or may form a block structure, R is a substituted or unsubstituted monovalent hydrocarbon group having 1 to 10 carbon atoms, R¹ is, independently of each other, a hydrogen atom or a monovalent hydrocarbon group having 1 to 10 carbon atoms, R² is a group represented by the following formula (1'), n¹ is an integer of 5 to 200, n² is an integer of 0 to 2, n³ is an integer of 0 to 10, n⁴ is 0 or 1, and the one or more of the R¹ is a hydrogen atom: 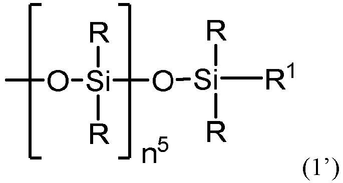
wherein R and R¹ are as defined above, and n⁵ is an integer of 1 to 10: 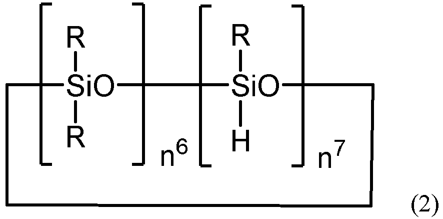
wherein each siloxane unit shown in parentheses may randomly bond or may form a block structure, R is as defined above, n⁶ is an integer of 1 to 10, n⁷ is 1 or 2, and n⁶ + n⁷ is 3 to 12: 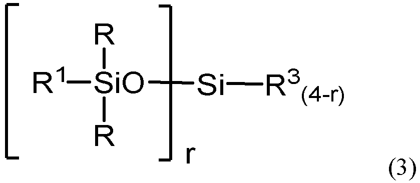
wherein R and R¹ are as defined above, r is an integer of 0 to 3, R³ is a hydrogen atom or at least one group selected from an alkyl group having 1 to 10 carbon atoms and an alkoxyalkyl group having 2 to 10 carbon atoms, and one or more of R¹s and R³s are a hydrogen atom.

5. The epoxy resin composition according to claim 1, wherein component (D) is a compound represented by the following formula (7): 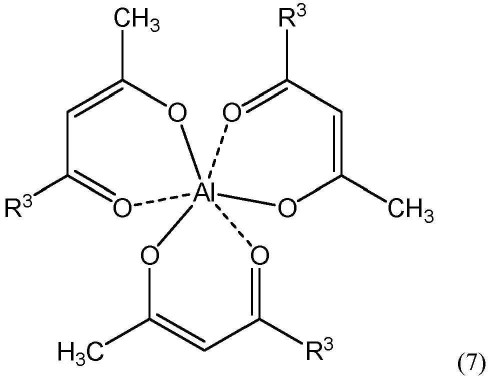 wherein R³ is, independently of each other, an alkoxy group having 1 to 4 carbon atoms or an alkyl group having 1 to 4 carbon atoms.

6. The epoxy resin composition according to claim 4, wherein component (D) is at least one selected from the group consisting of aluminum monoacetylacetonate-bis(ethyl acetoacetate) and aluminum-tris(acetylacetonate).

7. The epoxy resin composition according to claim **1,** wherein component (E) is an alkoxysilane having one or more phenyl groups per molecule and one or more alkoxy groups having 1 to 4 carbon atoms per molecule.

8. The epoxy resin composition according to claim **1,** wherein the silane compound of component (E) is a partially hydrolyzed condensate that is an oligomer having a polymerization degree of 5 or lower and containing one or more silanol groups.

9. The epoxy resin composition according to claim 1, wherein component (E) is at least one selected from an alkoxysilane represented by the following formula (8): 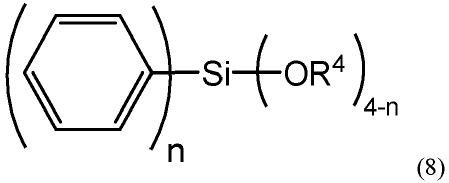
wherein R⁴ is an alkyl group having 1 to 4 carbon atoms and n is an integer of 1 to 3,
and an oligomer having a polymerization degree of 5 or lower that is a partially hydrolyzed condensate of said alkoxysilane.

10. The epoxy resin composition according to claim 1, wherein a mass ratio of component (D) to component (E) satisfies the equation (mass of component D)/(mass of component E) = 1/1 to 1/50.

11. The epoxy resin composition according to claim 1, wherein component (F) is the inorganic filler surface-treated with a silane coupling agent.

12. A potting agent comprising the epoxy resin composition according to any one of claims 1 to 11.

13. A power module encapsulated with the potting agent according to claim 12.

14. An underfill agent comprising the epoxy resin composition according to any one of claims 1 to 11.

15. A flip-chip package encapsulated with the underfill agent according to claim 14.

16. An epoxy resin adhesive comprising the epoxy resin composition according to any one of claims 1 to 11.

17. A semiconductor device comprising a layer formed from the epoxy resin adhesive according to claim 16.
